(19) Europäisches Patentamt
European Patent Office
Office européen des brevets

(11) **EP 3 239 460 A1**

(12) **EUROPÄISCHE PATENTANMELDUNG**

(43) Veröffentlichungstag:
**01.11.2017 Patentblatt 2017/44**

(51) Int Cl.:
*F01D 5/16* *(2006.01)*    *G06F 17/50* *(2006.01)*

(21) Anmeldenummer: **16167260.5**

(22) Anmeldetag: **27.04.2016**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**MA MD**

(71) Anmelder: **Siemens Aktiengesellschaft**
**80333 München (DE)**

(72) Erfinder:
• **Peeren, Christian**
  **47918 Tönisvorst (DE)**
• **Schmitt, Stefan**
  **45481 Mülheim an der Ruhr (DE)**
• **Stüer, Heinrich**
  **45721 Haltern (DE)**

(54) **VERFAHREN ZUM PROFILIEREN VON SCHAUFELN EINER AXIALSTRÖMUNGSMASCHINE**

(57)    Die Erfindung betrifft ein Verfahren zum Profilieren von Schaufeln einer Axialströmungsmaschine, mit den Schritten: a) Bereitstellen eines geometrischen Modells eines Schaufelprofils (R, -1, +1); b) Ermitteln einer Schwingungsform des geometrischen Modells; c) Berechnen eines zeitlichen Verlaufs eines ortsabhängigen Störbrucks $p(\vec{x},t)$ in einem Kanal (3) zwischen zwei benachbart angeordneten Schaufelprofilen über eine Schwingungsperiode der zu der Schwingungsform gehörigen Schwingung, wobei zum Berechnen des Verlaufs angenommen wird, dass der ortsabhängige Störbruck $p(\vec{x},t)$ in dem Kanal (3) proportional zu der Größe einer Fläche $A(\vec{x},t)$ ist, die in dem Kanal sich erstreckt und auf den den Kanal (3) begrenzenden Schaufeloberflächen senkrecht zu diesen Schaufeloberflächen und dazwischen senkrecht zu den Strömungslinien angeordnet ist, wobei $\vec{x}$ eine Koordinate auf der Schaufeloberfläche und t die Zeit ist;

d) Bestimmen der durch den Störbruckverlauf hervorgerufenen Dämpfung der Schwingung; d) Verändern des geometrischen Modells und ermitteln einer veränderten Schwingungsform für das veränderte geometrische Modell sowie Durchführen von Schritt c) mit dem veränderten geometrischen Modell und der veränderten Schwingungsform; e) Bestimmen der Dämpfung der Schwingung durch den in Schritt d) berechneten Störbruckverlauf $p(\vec{x},t)$ und Akzeptieren des veränderten geometrischen Modells für den Fall, dass die Dämpfung der Schwingung stärker als in Schritt c) ausfällt, ansonsten Wiederholen der Schritte d) und e) mit einem anderen veränderten geometrischen Modell.

FIG 1

**Beschreibung**

Die Erfindung betrifft ein Verfahren zum Profilieren von Schaufeln einer Axialströmungsmaschine.

Der Trend bei der Auslegung von Schaufeln für eine Axialströmungsmaschine geht dahin, das Aspektverhältnis der Schaufeln zu erhöhen und die Schaufeln dünner auszuführen. Die derart ausgelegten Schaufeln neigen dazu im Betrieb der Axialströmungsmaschine zu flattern. Bei dem Flattern handelt es sich um eine selbsterregte Schwingung bei der Eigenfrequenz der Schaufel. Bei dieser Schwingung kann es sich um eine Longitudinalschwingung der Schaufel mit einem Schwingungsknoten an dem Fuß der Schaufel handeln. Dabei wird Energie von dem in der Axialströmungsmaschine strömenden Fluid auf die Schaufel übertragen. Das Flattern kann bei einem wiederholten Lastwechsel der Axialströmungsmaschine zu einer Materialermüdung der Schaufel führen (englisch: high cycle fatigue). Die Materialermüdung kann zu der Bildung eines Risses führen und einen kostenintensiven Tausch der Schaufel erforderlich machen.

Herkömmlich wird das Flattern unterbunden, indem die auf die Schaufel wirkende Last vermindert wird. Dies führt jedoch nachteilig zu einer Verminderung des Wirkungsgrades der Axialströmungsmaschine. Außerdem werden herkömmlich Dämpfungselemente vorgesehen, wie beispielsweise ein Deckband, was das Flattern der Schaufeln dämpft. Dies stellt jedoch eine konstruktiv aufwändige Lösung dar. Daher wäre es wünschenswert die Schaufel derart auszulegen, dass sie im Betrieb der Axialströmungsmaschine nicht zum Flattern neigt.

Herkömmlich wird die Schaufel derart ausgelegt, dass in einem Vorauslegungsverfahren zuerst ein Schaufelprofil hinsichtlich der reduzierten Frequenz und des 0D Strouhal Kriteriums bewertet wird. Nach dem Vorauslegungsverfahren werden die akzeptierten Schaufelprofile in einer aufwändigen numerischen Schwingungssimulation bewertet. Die anhand der reduzierten Frequenz und des Strouhal Kriteriums bewerteten akzeptierten Schaufelprofile weisen jedoch in der Schwingungssimulation oftmals ein unakzeptables Flatterverhalten auf. Dies führt dazu, dass für viele verschiedene Schaufelprofile das Vorauslegungsverfahren und die numerische Schwingungssimulation wiederholt werden muss, was zeitaufwändig und kostenintensiv ist.

Aufgabe der Erfindung ist es daher, ein Verfahren zum Profilieren einer Schaufel einer Axialströmungsmaschine zu schaffen, welches wenig zeitaufwändig und wenig kostenintensiv ist.

Das erfindungsgemäße Verfahren zum Profilieren von Schaufeln einer Axialströmungsmaschine weist die Schritte auf: a) Bereitstellen eines geometrischen Modells eines Schaufelprofils; b) Ermitteln einer Schwingungsform des geometrischen Modells; c) Berechnen eines zeitlichen Verlaufs eines ortsabhängigen Stördrucks

$p(\vec{x},t) = p_{ges}(\vec{x},t) - p_0(\vec{x})$ (in einem Kanal zwischen zwei benachbart angeordneten Schaufelprofilen über eine Schwingungsperiode der zu der Schwingungsform gehörigen Schwingung, wobei zum Berechnen des Verlaufs angenommen wird, dass der ortsabhängige Stördruck $p(\vec{x},t)$ in dem Kanal proportional zu der Größe einer Fläche $A(\vec{x},t)$ ist, die in dem Kanal sich erstreckt und auf den zwei den Kanal begrenzenden Schaufeloberflächen senkrecht zu diesen Schaufeloberflächen und dazwischen senkrecht zu den Strömungslinien angeordnet ist, wobei $\vec{x}$ eine Koordinate auf einer der zwei Schaufeloberflächen, t die Zeit, $p_0(\vec{x})$ der ortsabhängige Druck bei still stehenden Schaufelprofilen und $p_{ges}(\vec{x},t)$ der ortsabhängige Gesamtdruck ist; d) Bestimmen der durch den Stördruckverlauf hervorgerufenen Dämpfung der Schwingung; d) Verändern des geometrischen Modells und ermitteln einer veränderten Schwingungsform für das veränderte geometrische Modell sowie Durchführen von Schritt c) mit dem veränderten geometrischen Modell und der veränderten Schwingungsform; e) Bestimmen der Dämpfung der Schwingung durch den in Schritt d) berechneten Stördruckverlauf $p(\vec{x},t)$ und Akzeptieren des veränderten geometrischen Modells für den Fall, dass die Dämpfung der Schwingung stärker als in Schritt c) ausfällt, ansonsten Wiederholen der Schritte d) und e) mit einem anderen veränderten geometrischen Modell.

Insbesondere aufgrund der Annahme, dass der Stördruck in dem Kanal proportional zu der Fläche $A(\vec{x},t)$ ist, ist das Verfahren wenig rechenintensiv. Die Annahme ist gültig für unendlich langsam schwingende Schaufelprofile. Überraschenderweise wurde trotz dieser Annahme gefunden, dass das akzeptierte geometrische Modell in einer anschließenden numerischen Schwingungssimulation gute Dämpfungseigenschaften zeigt. Daher ist es nicht erforderlich eine große Anzahl an den numerischen Schwingungssimulationen durchzuführen. Aufgrund des wenig rechenintensiven Verfahrens und der geringen Anzahl an den durchzuführenden numerischen Schwingungssimulationen ist das Verfahren vorteilhaft wenig aufwändig und wenig kostenintensiv.

Bevorzugt weist das Verfahren den Schritt auf: f) Numerisches Berechnen der anhand einer Strömung hervorgerufenen Schwingung des in Schritt e) akzeptierten geometrischen Modells und Berechnen der Dämpfung der Schwingung. Bei dem Verfahrensschritt f) handelt es um die vorgenannte numerische Schwingungssimulation. Die hier berechnete Dämpfung der Schwingung ist genauer als die in dem Verfahrensschritt d) bestimmte. Es ist hierbei bevorzugt, dass in dem Schritt f) die Konvektion und die Trägheit der Strömung berücksichtigt werden. Dadurch kann die Genauigkeit bei der Bestimmung der Dämpfung noch weiter gesteigert werden.

Es ist bevorzugt, dass die Schwingungsform in komplexer Form dargestellt wird: $\vec{\phi} = \vec{a}_c + i\vec{a}_s$, wobei $\vec{\phi}$ die Schwingungsform ist, $\vec{a}_c$ und $\vec{a}_s$ lokale Verformungen sind. Es ist hierbei bevorzugt, dass $\vec{a}_c$ und $\vec{a}_s$ mittels eines

Finiten Elemente Strukturlösers bereitgestellt werden.

Es ist bevorzugt, dass A($\vec{x}$,t) dargestellt wird gemäß

$$A(\vec{x}, t)$$

$$= A_0(\vec{x}) + \text{Re}\left[\left(\hat{A}_1 e^{i\beta_1} e^{i\sigma} + \hat{A}_R e^{i\beta_R}\right) e^{i\omega t}\right],$$

wobei $A_0(\vec{x})$ die Fläche A($\vec{x}$,t) bei still stehenden Schaufelprofilen, $\hat{A}_R = |\vec{n}_R \cdot \vec{\phi}|_R$ die Projek-tion der Schwingungsform auf die Normale $\vec{n}_R$ der Schaufeloberfläche bei der Koordinate $\vec{x}$ für das eine Schaufelprofil, $\hat{A}_1 = |\vec{n}_1 \cdot \vec{\phi}|_1$ die Projektion der Schwingungsform auf die Normale $\vec{n}_1$ der Schaufeloberfläche bei einem Punkt auf der Schaufeloberfläche des anderen Schaufelprofils, $\beta_1$ und $\beta_R$ der jeweilige Phasenversatz zwischen dem Imaginärteil und dem Realteil, $\sigma$ der Phasenversatz der Schwingungen der beiden Schaufelprofile und $\omega$ die Kreisfrequenz ist. Dies beinhaltet als Näherung, dass sich das Schaufelprofil während der Schwingung senkrecht zu seiner Schaufeloberfläche bewegt. Diese Näherung ist insbesondere gültig bei kleinen Auslenkungen der Schaufel während ihrer Schwingung. Durch diese Näherung ist das Verfahren vorteilhaft wenig rechenintensiv. Trotz dieser Näherung hat das akzeptierte geometrische Modell vorteilhaft gute Dämpfungseigenschaften.

Es ist bevorzugt, dass $A_0(\vec{x})$ bestimmt wird, indem bei der Koordinate $\vec{x}$ auf der Schaufeloberfläche des einen Schaufelprofils ein Kreis gefunden wird, der die Schaufeloberfläche des einen Schaufelprofils bei der Koordinate $\vec{x}$ und die Schaufeloberfläche des anderen Schaufelprofils in dem Punkt tangiert, und $A_0(\vec{x})$ derart gewählt wird, dass $A_0(\vec{x})$ von der Normalen $\vec{n}_R$ bei der Koordinate $\vec{x}$ und von der Normalen $\vec{n}_1$ an dem Punkt tangiert wird. Dies stellt vorteilhaft einen einfachen Verfahrensschritt zum Bestimmen der Fläche $A_0(\vec{x})$ dar. Zusammen mit der Annahme, dass die Schaufelprofile sich während der Schwingung normal zur Schaufeloberfläche bewegen, ist die zeitliche Änderung der Fläche $A_0(\vec{x}$,t) genau definiert. $A_0(\vec{x})$ wird bevorzugt bestimmt durch Interpolieren einer Funktion, insbesondere ein Polynom zweiten Grades, zwischen der Koordinate $\vec{x}$ und dem Punkt. Dies stellt ein besonders einfaches Verfahren zum Bestimmen der Fläche $A_0(\vec{x})$ dar. Beispielsweise ist es dadurch nicht erforderlich eine Strömungssimulation zum Bestimmen der Strömungslinien durchzuführen. Trotz dieses einfachen Verfahrens zum Bestimmen der Fläche $A_0(\vec{x})$ hat das akzeptierte geometrische Modell vorteilhaft gute Dämpfungseigenschaften.

Es ist bevorzugt, dass in Schritt d) die Dämpfung der Schwingung für verschiedene Werte für $\beta_1$, $\beta_R$ und $\sigma$ bestimmt wird. Dadurch lässt sich die Zeitabhängigkeit der Fläche $A_0(\vec{x}$,t) bestimmen. Ferner ist es bevorzugt, dass in Schritt d) eine Integration des ortsabhängigen Stördrucks entlang des vollständigen Kanals vorgenommen wird.

Im Folgenden wird anhand der beigefügten schematischen Zeichnungen die Erfindung näher erläutert. Es zeigen

Figur 1 einen Querschnitt durch drei benachbart angeordnete Schaufeln,

Figur 2 ein Detail aus Figur 1,

Figur 3 eine Darstellung eines Kanals zwischen zwei benachbart angeordneten Schaufeln,

Figur 4 eine Darstellung einer Schwingungsform einer Schaufel und

Figur 5 einen Dämpfungsverlauf über eine Schwingungsperiode für verschiedene reduzierte Frequenzen.

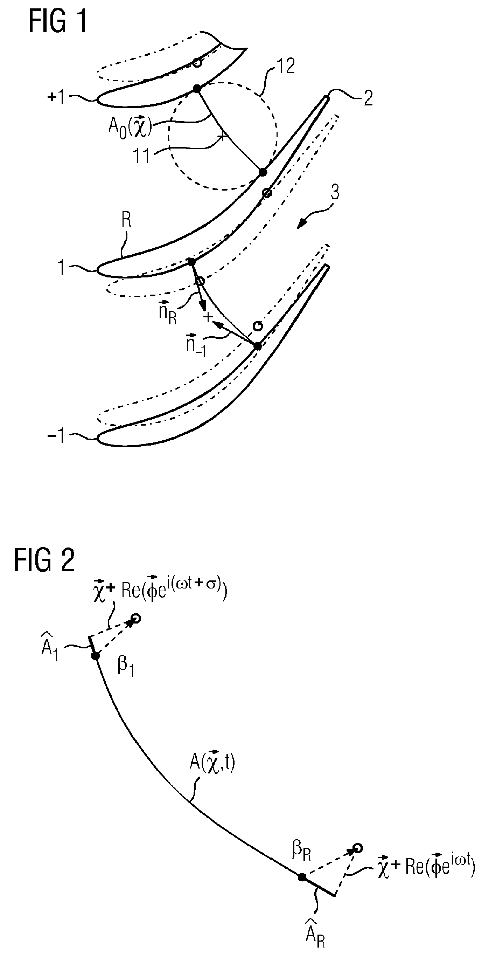

Eine Axialströmungsmaschine, wie beispielsweise eine Gasturbine oder eine Dampfturbine, weist Reihen von Schaufeln auf. Bei den Schaufeln kann es sich um Leitschaufeln und/oder Laufschaufeln handeln, die in einem Verdichter und/oder in einer Turbine angeordnet sind. Figur 1 zeigt drei in einer Reihe benachbart angeordnete Schaufeln. Dargestellt ist jeweils ein geometrisches Modell eines Schaufelprofils für jede der drei Schaufeln. Das mittlere Schaufelprofil ist als ein Referenzschaufelprofil R und die beiden zu dem Referenzschaufelprofil R benachbarten Schaufelprofile sind als ein erstes benachbartes Schaufelprofil +1 und als ein zweites benachbartes Schaufelprofil -1 bezeichnet. Jedes der Schaufelprofile R, -1, +1 weist jeweils eine Vorderkante 1 und eine Hinterkante 2 auf. Zwischen zwei benachbart angeordneten Schaufelprofilen ist jeweils ein Kanal 3 angeordnet, in dem im Betrieb der Axialströmungsmaschine ein Arbeitsfluid strömt. Die durchgezogenen Linien in Figur 1 stellen die Schaufelprofile R, +1, -1 in ihrem still stehenden Zustand dar. Die gestrichelten Linien stellen die Schwingung der Schaufelprofile R, +1, -1 dar, wobei das erste benachbarte Schaufelprofil +1 und das zweite benachbarte Schaufelprofil -1 eine gleiche Schwingungsphase haben, die zu der Schwingungsphase des Referenzschaufelprofils R versetzt ist.

In dem Verfahren zum Profilieren der Schaufel wird in einem Schritt a) das geometrische Modell des Schaufelprofils R, -1, +1 bereitgestellt, wobei die Schaufelprofile R, -1, +1 in einer Reihe von Schaufeln identisch sind.

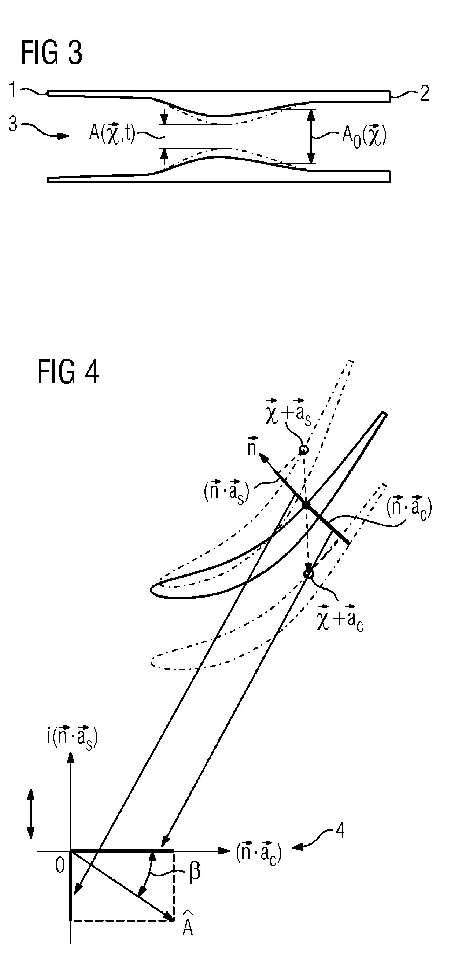

In einem Schritt b) wird die Schwingungsform $\vec{\phi}$ des geometrischen Modells ermittelt. Wie es aus Figur 4 ersichtlich ist, kann die Schwingungsform $\vec{\phi}$ in komplexer Form gemäß $\vec{\phi} = \vec{a}_c + i\vec{a}_s$ dargestellt werden, wobei $\vec{a}_c$ und $\vec{a}_s$ lokale Verformungen sind. Die Schwingungsform ergibt sich dann als Überlagerung dieser beiden Formen. In Figur 4 ist diese Überlagerung in einem Zeigerdiagramm 4 dargestellt, wobei der Phasenversatz zwischen Realteil und Imaginärteil mit $\beta$ bezeichnet ist.

$\vec{a}_c$ und $\vec{a}_s$ können mittels eines Finite Elemente Strukturlösers bestimmt werden, wobei der Finite Elemente Strukturlöser als eine Eingabe das Schaufelprofil erhält.

In einem Schritt c) wird ein zeitlicher Verlauf eines ortsabhängigen Störrucks $p(\vec{x},t)$ in dem Kanal 3 über eine Schwingungsperiode der zu der Schwingungsform gehörigen Schwingung berechnet. $\vec{x}$ ist dabei eine Koordinate auf der Oberfläche einer der beiden benachbarten Schaufelprofilen und t ist die Zeit. Zum Berechnen des Störrucks $p(\vec{x},t)$ wird angenommen, dass der ortsabhängige Störruck $p(\vec{x},t)$ in dem Kanal 3 proportional zu der Größe einer Fläche $A(\vec{x},t)$ ist, die in dem Kanal sich erstreckt und auf den den Kanal 3 begrenzenden Schaufeloberflächen senkrecht zu diesen Schaufeloberflächen und dazwischen senkrecht zu den Strömungslinien angeordnet ist.

Die Näherung, dass der Störruck $p(\vec{x},t)$ als proportional zu der Fläche $A(\vec{x},t)$ angenommen wird, ist in Figur 3 illustriert. Die durchgezogenen Linien in Figur 3 stellen die zwei den Kanal 3 begrenzenden Schaufeloberflächen in ihrem still stehenden Zustand dar. Die gestrichelten Linien stellen die zwei den Kanal 3 begrenzenden Schaufeloberflächen mit einer Auslenkung während ihrer Schwingung dar. Bei einer kleinen Fläche $A(\vec{x},t)$ ist im Betrieb der Axialströmungsmaschine die Geschwindigkeit des Arbeitsfluids hoch, wodurch ein niedriger Störruck $p(\vec{x},t)$ herrscht. Umgekehrt gilt analog, dass bei einer großen Fläche $A(\vec{x},t)$ im Betrieb der Axialströmungsmaschine die Geschwindigkeit des Arbeitsfluids niedrig ist, wodurch ein hoher Störruck $p(\vec{x},t)$ herrscht.

$A(\vec{x},t)$ wird dargestellt gemäß

$$A(\vec{x},t) = A_0(\vec{x}) + \mathrm{Re}$$

$$\left[\left(\hat{A}_1 e^{i\beta_1} e^{i\sigma} + \hat{A}_R e^{i\beta_R}\right) e^{i\omega t}\right],$$ wobei $A_0(\vec{x})$ die Fläche $A(\vec{x},t)$ bei still stehenden Schaufelprofilen ist. $A_0(\vec{x})$ kann, wie in Figur 1 gezeigt, bestimmt werden, indem bei der Koordinate $\vec{x}$ auf der Schaufeloberfläche des einen Schaufelprofils ein Kreis 12 gefunden wird, der die Schaufeloberfläche des einen Schaufelprofils bei der Koordinate $\vec{x}$ und die Schaufeloberfläche des anderen Schaufelprofils in einem Punkt tangiert. Für den Fall, dass mehrere der Kreise 12 gefunden werden können, so wird der Kreis 12 mit dem kürzesten Durchmesser ausgewählt. $A_0(\vec{x})$ wird anschließend derart gewählt, dass $A_0(\vec{x})$ von der Normalen $\vec{n}_R$ auf der Oberfläche des einen Schaufelprofils bei der Koordinate $\vec{x}$ und von der Normalen $\vec{n}_1$ auf der Oberfläche des anderen Schaufelprofils an dem Punkt tangiert wird. Dazu wird $A_0(\vec{x})$ bestimmt durch Interpolieren einer Funktion zwischen der Koordinate $\vec{x}$ und dem Punkt. Beispielsweise kann die Funktion ein Polynom zweiten Grades sein. Wie es aus Figur 1 ersichtlich ist, weisen beide Normale $\vec{n}_R$ und $\vec{n}_1$ auf den Kreismittelpunkt 11 des Kreises 12, was eine Konsequenz davon ist, dass der Kreis 12 die beiden Schaufeloberflächen in der Koordinate $\vec{x}$ und dem Punkt tangiert.

$\hat{A}_R = |\vec{n}_R \cdot \vec{\phi}|_R$ ist die Projektion der Schwingungsform $\vec{\phi}$ auf die Normale $\vec{n}_R$ der Schaufeloberfläche bei der Koordinate $\vec{x}$ für das eine Schaufelprofil. $\hat{A}_1 = |\vec{n}_1 \cdot \vec{\phi}|_1$ ist die Projektion der Schwingungsform $\vec{\phi}$ auf die Normale $\vec{n}_1$ der Schaufeloberfläche bei dem Punkt auf der Schaufeloberfläche des anderen Schaufelprofils. Die jeweiligen Projektionen $\hat{A}_R$ und $\hat{A}_1$ sind in Figur 2 als die Linien von dem jeweiligen Punkt bis zum jeweiligen Ende der Linien dargestellt. $\beta_1$ und $\beta_R$ sind der jeweilige Phasenversatz zwischen dem Imaginärteil und dem Realteil. $\sigma$ ist der Phasenversatz der Schwingungen der beiden Schaufelprofile und $\omega$ ist die Kreisfrequenz.

In einem Schritt d) wird die durch den Störruckverlauf hervorgerufenen Dämpfung der Schwingung bestimmt. Dazu wird der Störruck mit der Projektion der Schwingungsform auf die Normale der Schaufeloberfläche multipliziert. Das dabei erhaltene Produkt wird über den gesamten Kanal 3 integriert, wodurch sich die Dämpfung ergibt.

In einem Schritt d) wird das geometrische Modell verändert und eine veränderte Schwingungsform für das veränderte geometrische Modell ermittelt. In dem Schritt d) wird zudem Schritt c) mit dem veränderten geometrischen Modell und der veränderten Schwingungsform durchgeführt.

In einem Schritt e) wird die Dämpfung der Schwingung durch den in Schritt d) berechneten Störruckverlauf $p(\vec{x},t)$ bestimmt. Das verändertete geometrische Modell wird akzeptiert für den Fall, dass die Dämpfung der Schwingung stärker als in Schritt c) ausfällt, ansonsten werden die Schritte d) und e) mit einem anderen veränderten geometrischen Modell wiederholt.

In Schritt d) kann die Dämpfung der Schwingung für verschiedene Werte für $\beta_1$, $\beta_R$ und $\sigma$ bestimmt wird, so dass die Zeitabhängigkeit der Fläche $A(\vec{x},t)$ erhalten.

In einem Schritt f) erfolgt ein numerisches Berechnen der anhand einer Strömung hervorgerufenen Schwingung des in Schritt e) akzeptierten geometrischen Modells und ein Berechnen der Dämpfung der Schwingung.

Der in Schritt c) berechnete Störruck $p(\vec{x},t)$ und die in Schritt d) berechnete Dämpfung stellen eine Näherung für den Fall $k \to 0$ dar, wobei $k$ die reduzierte Frequenz ist. Die re-duzierte Frequenz kann bestimmt werden gemäß

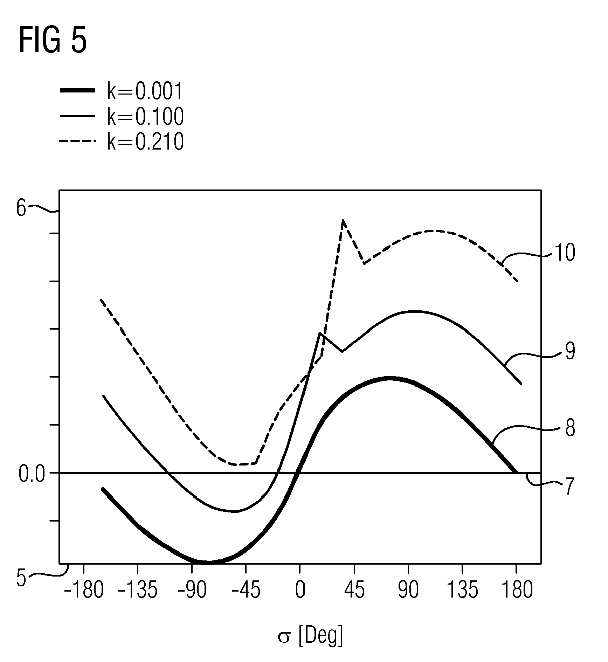

$$k = \frac{2 * \Pi * c * f}{U},$$ wobei f die Frequenz der Schwingung, c die Sehnenlänge des Schaufelprofils und $U$ die Geschwindigkeit des Arbeitsfluids in einer Axialposition der Strömungsmaschine, in der die Vorderkanten 1 der Schaufelprofile liegen, ist. In Figur 5 ist der in Schritt f) berechnete Dämpfungsverlauf über eine Schwingungsperiode für verschiedene reduzierte Frequenzen $k$ dargestellt. Das dem Schritt f) zugrunde liegende geometrische Modell ist ein in dem Schritt e) akzeptiertes geometrisches Modell. Über der Abszisse 5 ist der Phasenwinkel $\sigma$ und über der Ordinate 6 ist die Dämpfung aufgetragen. Ebenfalls ist in Figur 5 eine Nulllinie 7 der Dämpfung eingetragen, wobei negative Werte für die Dämpfung eine Anregung der Schwingung bedeuten und positive Werte für die Dämpfung eine Dämpfung der Schwingung bedeuten.

Figur 5 weist einen Dämpfungswertverlauf 8 bei k=0,001, einen Dämpfungswertverlauf 9 bei k=0,1 und einen Dämpfungswertverlauf 10 bei k=0,21 auf. Der Dämpfungswertverlauf 8 ist aufgrund dessen geringer reduzierter Frequenz vergleichbar mit dem in dem Schritt d) bestimmten. Erkennbar ist, dass mit zunehmender reduzierter Frequenz die Dämpfung der Schwingung zunimmt. Das in Schritt e) akzeptierte geometrische Modell stellt damit einen guten Ausgangspunkt für die anschließende numerische Simulation der Schwingung dar.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

**Patentansprüche**

1. Verfahren zum Profilieren von Schaufeln einer Axialströmungsmaschine, mit den Schritten:

   a) Bereitstellen eines geometrischen Modells eines Schaufelprofils (R, -1, +1) ;
   b) Ermitteln einer Schwingungsform des geometrischen Modells;
   c) Berechnen eines zeitlichen Verlaufs eines ortsabhängigen Stördrucks $p(\vec{x},t)$ =$p_{ges}$ $(\vec{x},t)$ -$p_0(\vec{x})$ in einem Kanal (3) zwischen zwei benachbart angeordneten Schaufelprofilen über eine Schwingungsperiode der zu der Schwingungsform gehörigen Schwingung, wobei zum Berechnen des Verlaufs angenommen wird, dass der ortsabhängige Stördruck $p(\vec{x},t)$ in dem Kanal (3) proportional zu der Größe einer Fläche $A(\vec{x},t)$ ist, die in dem Kanal sich erstreckt und auf den zwei den Kanal (3) begrenzenden Schaufeloberflächen senkrecht zu diesen Schaufeloberflächen und dazwischen senkrecht zu den Strömungslinien angeordnet ist, wobei $\vec{x}$ eine Koordinate auf einer der zwei Schaufeloberflächen, t die Zeit, $p_0(\vec{x})$ der ortsabhängige Druck bei still stehenden Schaufelprofilen und $p_{ges}(\vec{x},t)$ der ortsabhängige Gesamtdruck ist;
   d) Verändern des geometrischen Modells und ermitteln einer veränderten Schwingungsform für das veränderte geometrische Modell sowie Durchführen von Schritt c) mit dem veränderten geometrischen Modell und der veränderten Schwingungsform;
   e) Bestimmen der Dämpfung der Schwingung durch den in Schritt d) berechneten Störckruckverlauf $p(\vec{x},t)$ und Akzeptieren des veränderten geometrischen Modells für den Fall, dass die Dämpfung der Schwingung stärker als in Schritt c) ausfällt, ansonsten Wiederholen der Schritte d) und e) mit einem anderen veränderten geometrischen Modell.

2. Verfahren gemäß Anspruch 1, mit dem Schritt:

   f) Numerisches Berechnen der anhand einer Strömung hervorgerufenen Schwingung des in Schritt e) akzeptierten geometrischen Modells und Berechnen der Dämpfung der Schwingung.

3. Verfahren gemäß Anspruch 2, wobei in Schritt f) die Konvektion und die Trägheit der Strömung berücksichtigt werden.

4. Verfahren gemäß einem der Ansprüche 1 bis 3, wobei die Schwingungsform in komplexer Form dargestellt wird: $\vec{\phi} = \vec{a}_c + i\vec{a}_s$, wobei $\vec{\phi}$ die Schwingungsform ist, $\vec{a}_c$ und $\vec{a}_s$ lokale Verformungen sind.

5. Verfahren gemäß Anspruch 4, wobei $\vec{a}_c$ und $\vec{a}_s$ mittels eines Finiten Elemente Strukturlösers bereitgestellt werden.

6. Verfahren gemäß Anspruch 4 oder 5,
   wobei $$A(\vec{x},t) = A_0(\vec{x}) + \mathrm{Re}\left[\left(\hat{A}_1 e^{i\beta_1} e^{i\sigma} + \hat{A}_R e^{i\beta_R}\right) e^{i\omega t}\right],$$ wobei $A_0(\vec{x})$ die Fläche $A(\vec{x},t)$ bei still stehenden Schaufelprofilen, $\hat{A}_R = |\vec{n}_R \cdot \vec{\phi}|_R$ die Projektion der Schwingungsform auf die Normale $\vec{n}_R$ der Schaufeloberfläche bei der Koordinate $\vec{x}$ für das eine Schaufelprofil, $\hat{A}_1 = |\vec{n}_1 \cdot \vec{\phi}|_1$ die Projektion der Schwingungsform auf die Normale $\vec{n}_1$ der Schaufeloberfläche bei einem Punkt auf der Schaufeloberfläche des anderen Schaufelprofils, $\beta_1$ und $\beta_R$ der jeweilige Phasenversatz zwischen dem Imaginärteil und dem Realteil, $\sigma$ der Phasenversatz der Schwingungen der beiden Schaufelprofile und $\omega$ die Kreisfrequenz ist.

7. Verfahren gemäß Anspruch 6, wobei $A_0(\vec{x})$ bestimmt wird, indem bei der Koordinate $\vec{x}$ auf der Schaufeloberfläche des einen Schaufelprofils ein Kreis (12) gefunden wird, der die Schaufeloberfläche des einen Schaufelprofils bei der Ko-

ordinate $\vec{x}$ und die Schaufeloberfläche des anderen Schaufelprofils in dem Punkt tangiert, und $A_0(\vec{x})$ derart gewählt wird, dass $A_0(\vec{x})$ von der Normalen $\vec{n}_R$ bei der Koordinate $\vec{x}$ und von der Normalen $\vec{n}_1$ an dem Punkt tangiert wird.

8. Verfahren gemäß Anspruch 7, wobei $A_0(\vec{x})$ bestimmt wird durch Interpolieren einer Funktion, insbesondere ein Polynom zweiten Grades, zwischen der Koordinate $\vec{x}$ und dem Punkt.

9. Verfahren gemäß einem der Ansprüche 6 bis 8, wobei in Schritt d) die Dämpfung der Schwingung für verschiedene Werte für $\beta_1$, $\beta_R$ und $\sigma$ bestimmt wird.

10. Verfahren gemäß einem der Ansprüche 1 bis 9, wobei in Schritt d) eine Integration des ortsabhängigen Stördrucks entlang des vollständigen Kanals (3) vorgenommen wird.

FIG 1

FIG 2

# FIG 3

# FIG 4

# FIG 5

Europäisches
Patentamt

European
Patent Office

Office européen
des brevets

# EUROPÄISCHER RECHERCHENBERICHT

Nummer der Anmeldung

EP 16 16 7260

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | EP 1 528 223 A2 (ROLLS ROYCE PLC [GB]) 4. Mai 2005 (2005-05-04) * Absätze [0082] - [0086] * * Abbildung 9 * ----- | 1-10 | INV. F01D5/16 G06F17/50 |
| A | US 2010/050594 A1 (LOMBARD JEAN-PIERRE FRANCOIS [FR] ET AL) 4. März 2010 (2010-03-04) * Absätze [0036] - [0061] * * Abbildungen 1-5 * ----- | 1-10 | |
| A | US 2014/112760 A1 (DUONG LOC QUANG [US] ET AL) 24. April 2014 (2014-04-24) * das ganze Dokument * ----- | 1-10 | |

RECHERCHIERTE
SACHGEBIETE (IPC)

F01D
F04D
G06F

Der vorliegende Recherchenbericht wurde für alle Patentansprüche erstellt

| Recherchenort | Abschlußdatum der Recherche | Prüfer |
|---|---|---|
| München | 27. September 2016 | de la Loma, Andrés |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes
   Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 16 16 7260

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

27-09-2016

| Im Recherchenbericht angeführtes Patentdokument | Datum der Veröffentlichung | Mitglied(er) der Patentfamilie | Datum der Veröffentlichung |
|---|---|---|---|
| EP 1528223 A2 | 04-05-2005 | EP 1528223 A2<br>US 2005096891 A1<br>US 2009055146 A1 | 04-05-2005<br>05-05-2005<br>26-02-2009 |
| US 2010050594 A1 | 04-03-2010 | FR 2935427 A1<br>GB 2462921 A<br>US 2010050594 A1 | 05-03-2010<br>03-03-2010<br>04-03-2010 |
| US 2014112760 A1 | 24-04-2014 | CA 2888919 A1<br>EP 2912278 A1<br>US 2014112760 A1<br>WO 2014066199 A1 | 01-05-2014<br>02-09-2015<br>24-04-2014<br>01-05-2014 |

EPO FORM P0461

Für nähere Einzelheiten zu diesem Anhang : siehe Amtsblatt des Europäischen Patentamts, Nr.12/82